# EUROPÄISCHE PATENTSCHRIFT

(11) **EP 2 702 620 B1**
(45) Veröffentlichungstag und Bekanntmachung des Hinweises auf die Patenterteilung: **18.12.2019**
(21) Anmeldenummer: 12721202.5
(22) Anmeldetag: 26.04.2012
(51) Int. Cl.: H01L 51/52

(54) **LICHTABGEBENDES ELEMENT MIT EINER OLED ODER QLED**
LIGHT-EMITTING ELEMENT HAVING AN OLED OR QLED
ÉLÉMENT LUMINESCENT MUNI D'UNE OLED OU D'UNE QLED

(30) Priorität: 28.04.2011 DE 102011017728
(43) Veröffentlichungstag der Anmeldung: 05.03.2014
(73) Patentinhaber: Tridonic GmbH & Co KG, 6851 Dornbirn (AT)
(72) Erfinder: KIRCHHOF, Christian, 01099 Dresden (DE); AMELUNG, Jörg, 01099 Dresden (DE)
(74) Vertreter: Thun, Clemens
(86) Internationale Anmeldenummer: PCT/EP2012/057603
(87) Internationale Veröffentlichungsnummer: WO 2012/146633

(56) Entgegenhaltungen:
- EP-A1- 2 503 620
- EP-A2- 2 301 739
- WO-A1-2010/113737
- GB-A- 2 464 111
- JP-A- 2004 063 209
- JP-A- 2008 066 027

## Beschreibung

Die Erfindung betrifft ein lichtabgebendes Element mit einer flächigen OLED (organic light emitting diode; organische lichtemittierende Diode bzw. Leuchtdiode) oder einer flächigen QLED (Quantendotleuchtdiode) zur Erzeugung eines ersten Lichts.

Auf Basis organischer Leuchtdioden bzw. Quantendotleuchtdioden können neuartige lichtabgebende Elemente verwirklicht werden, die über eine Lichtabgabefläche hinweg Licht abgeben, also sozusagen "Flächenlichtelemente". Im Vergleich zu einer LED (light emitting diode; lichtemittierende Diode bzw. Leuchtdiode) gibt eine OLED bzw. QLED Licht mit einer moderateren Leuchtdichte ab; hierdurch ist sie für die Herstellung flächiger diffuser Lichtquellen besonders gut geeignet.

Standardgemäß beinhaltet eine OLED bzw. QLED eine ca. 100 nm starke, transparente Schicht aus Indium-Zinn-Oxid (ITO) auf Glas (das als Substrat dient), eine darauf angeordnete organische Schicht (mit teilweise bis zu sieben Sublagen) mit einer Stärke von ca. 100 bis 200 nm und eine weitere Schicht in Form einer metallischen Kathode (meistens Aluminium) mit einer Stäke von ca. 100 bis 500 nm.

Bei einer OLED bzw. QLED ist in der Regel eine Lichtabgabe erwünscht, die über die lichtabgebende äußere Begrenzungsfläche hinweg betrachtet möglichst homogen erscheint. Eine OLED bzw. QLED ist ein stromgetriebenes Bauelement und zur Erzielung einer möglichst homogenen Lichtabgabe ist es zunächst erforderlich, eine möglichst homogene Stromverteilung über die Leuchtfläche bzw. Lichtabgabefläche zu bewirken. Hierbei ist weiterhin zu berücksichtigen, dass eine OLED bzw. QLED eine transparente Elektrode aufweist, durch die das Licht hindurchtreten muss, bevor es nach außen abgegeben wird. Diese Elektrode besteht in der Regel aus transparenten leitfähigen Oxiden (TCO) oder sehr dünnen Metallschichten und die geringe Leitfähigkeit dieser Schichten trägt merklich zur Inhomogenität der Lichtabgabe bei.

Aus der WO 2010/113737 A1 ist eine Anordnung mit einem Elektrolumineszenz-Element und einer optischen Folie bekannt. Die optische Folie weist auf derjenigen Seite, die dem Elektrolumineszenz-Element gegenüberliegt, eine strukturierte Oberfläche auf.

Aus der GB 2 464 111 A ist eine OLED-Anordnung mit einem optischen Film bekannt; der optische Film ist auf beiden Seiten strukturiert, wobei er auf derjenigen Seite, die der OLED zugewandt ist, ein optisches Gitter aufweist und auf der gegenüberliegenden Seite Mikrolinsen.

Eine weitere Licht abgebende Anordnung mit einer OLED ist aus der Schrift JP 2004-063209 A bekannt.

Aus der JP 2008 066027 A ist ein geschichteter Leuchtkörper bekannt, in folgender Bauweise: über einer ebenfalls schichtweise aufgebauten Substratschicht befindet sich eine transparente Elektrode, darüber die Licht-erzeugende organische EL-Schicht und wieder darüber eine reflektierende Elektrode. Der Aufbau der Substratschicht ist wie folgt: angrenzend an die Elektrode befindet sich die erste hochbrechende Oberflächenschicht eines Trägers, dessen zweite niedrig brechende Oberflächenschicht den Abschluss der Lichtaustrittsseite des Leuchtkörpers bildet. Beide Oberflächenschichten, zumindest aber die Elektroden-seitige Oberflächenschicht, sind Trägerseitig uneben bzw. weisen eine Anzahl von Unebenheiten auf.

Aus der EP 2 503 620 A1 ist eine organische elektrolumineszierende Vorrichtung bekannt, mit folgendem Schichtaufbau: eine lichterzeugende Lumineszenzschicht weist lichtaustrittsseitig eine transparente erste Elektrode auf sowie eine reflektierende zweite Elektrode auf der anderen Seite. An die erste Elektrode angrenzend befindet sich eine ebenso schichtweise aufgebaute Lichtextraktionsschicht. Letztere besteht lichtaustrittsseitig aus einer Substratschicht sowie Elektroden-seitig aus einer Planarisierungsschicht, welche Substrat-seitig eine konvexe Struktur aufweist. Dieses Dokument wurde nach dem Anmeldedatum veröffentlicht.

Der Erfindung liegt die Aufgabe zugrunde, ein entsprechendes lichtabgebendes Element zu verbessern; insbesondere soll bei vergleichsweise einfacher Ausführung eine besonders hohe Lichtausbeute ermöglicht sein, sowie eine gezielte Lichtlenkung.

Diese Aufgabe wird gemäß der Erfindung mit dem in dem unabhängigen Anspruch genannten Gegenstand gelöst. Besondere Ausführungsarten der Erfindung sind in den abhängigen Ansprüchen angegeben.

Gemäß der Erfindung ist ein lichtabgebendes Element vorgesehen, das eine flächige OLED oder eine flächige QLED zur Erzeugung eines ersten Lichts aufweist. Weiterhin weist das Element ein optisches Beeinflussungselement mit einer Lichtabgabefläche zur Abgabe eines zweiten Lichts auf, wobei das zweite Licht durch eine, zumindest teilweise durch das optische Beeinflussungselement bewirkte, optische Beeinflussung aus dem ersten Licht gebildet ist.

Mit dem optischen Beeinflussungselement lässt sich sowohl eine Erhöhung der Lichtausbeute bewirken, als auch eine gezielte Beeinflussung des Richtungsverhaltens des zweiten Lichts.

Erfindungsgemäß umfasst das optische Beeinflussungselement eine Primäroptik sowie eine Sekundäroptik zur optischen Beeinflussung. Die Primäroptik ist dabei auf einer Seite des optischen Beeinflussungselements ausgebildet, die zu der OLED bzw. QLED weist. Mit der Primäroptik kann insbesondere die Lichtausbeute erhöht werden und mit der Sekundäroptik lässt sich insbesondere eine gezielte Lichtlenkung bewirken.

Die vorliegende Erfindung ist insbesondere dadurch gekennzeichnet, dass die Primäroptik Mikrolinsen umfasst, wobei - mit Bezug auf die Lichtabgabefläche - in einem Randbereich des optischen Beeinflussungselements anders geformte Mikrolinsen als Lichtbeeinflussungselemente angeordnet sind, als in einem mittleren Bereich.

Die Sekundäroptik ist vorteilhaft zumindest teilweise durch eine Strukturierung der Lichtabgabefläche gebildet. Hierdurch ist ein besonders einfacher Aufbau des Elements ermöglicht. Die Primäroptik umfasst Mikrolinsen; die Sekundäroptik umfasst vorzugsweise Prismen.

Vorteilhaft weist das optische Beeinflussungselement normal zur Lichtabgabefläche betrachtet ungleichmäßig ausgebildete Lichtbeeinflussungselemente auf. Auf diese Weise lässt sich gezielt Einfluss auf die Homogenität der Lichtabgabe über die Lichtabgabefläche bewirken. Insbesondere lässt sich durch entsprechend gewählte Ausbildung der Lichtbeeinflussungselemente eine erhöhte Homogenität erzielen.

Vorteilhaft umfasst die OLED bzw. QLED eine Grundelektrode, Elementschichten und eine Deckelektrode.

Wenn das optische Beeinflussungselement ein einteiliges Bauteil ist, ist ein besonders einfacher Aufbau des lichtabgebenden Elements ermöglicht. Außerdem ist in diesem Fall eine räumliche Beziehung zwischen der Primäroptik und der Sekundäroptik bzw. der entsprechenden einzelnen Lichtbeeinflussungselemente durch das Bauteil an sich festgelegt, so dass auf eine entsprechende relative Positionierung beim Zusammenbau des Elements nicht geachtet werden muss.

Weiterhin vorteilhaft weist das Element außerdem ein Substrat auf, wobei die OLED bzw. QLED auf einer ersten Seite des Substrats angeordnet ist, sowie eine Verbindungsschicht, die in einem Zwischenbereich zwischen einer, der ersten Seite gegenüberliegenden, zweiten Seite des Substrats einerseits und dem optischen Beeinflussungselement andererseits angeordnet ist. Durch die Verbindungsschicht lässt sich eine weitergehende vorteilhafte optische Beeinflussung des ersten Lichts zur Bildung des zweiten Lichts erzielen, insbesondere zur Vergrößerung des Verhältnisses der Intensität des zweiten Lichts zur Intensität des ersten Lichts, also zur Erhöhung der Lichtausbeute.

Ein besonders einfacher Aufbau ist dabei weiterhin ermöglicht, wenn das optische Beeinflussungselement durch die Verbindungsschicht an dem Substrat gehaltert ist. Vorzugsweise umfasst die Verbindungsschicht hierzu einen Klebstoff oder besteht aus einem solchen.

Weiterhin vorteilhaft weist das Element außerdem eine Deckschicht auf, insbesondere in Form eines Deckglases, wobei die OLED bzw. QLED zwischen dem Substrat und der Deckschicht angeordnet ist. Hierdurch ist ein besonders guter Schutz der OLED bzw. QLED ermöglicht. Wenn dabei die Deckschicht lichtdurchlässig ist, ist eine Lichtabgabe des Elements in zwei gegenüberliegende Richtungen ermöglicht.

Vorteilhaft ist die OLED bzw. QLED transparent. Hierdurch ist vorteilhaft eine beidseitige Lichtabgabe ermöglicht.

Die Erfindung wird im Folgenden anhand von Ausführungsbeispielen und mit Bezug auf die Zeichnungen näher erläutert. Es zeigen:
- Fig. 1: eine Skizze eines ersten, nicht erfindungsgemäßen Beispiels eines lichtabgebenden Elements,
- Fig. 2: eine entsprechende Skizze zu einem zweiten, nicht erfindungsgemäßen Beispiel,
- Fig. 3: eine entsprechende Skizze zu einem dritten, nicht erfindungsgemäßen Beispiel und
- Fig. 4: eine entsprechende Skizze zu einem erfindungsgemäßen Ausführungsbeispiel.

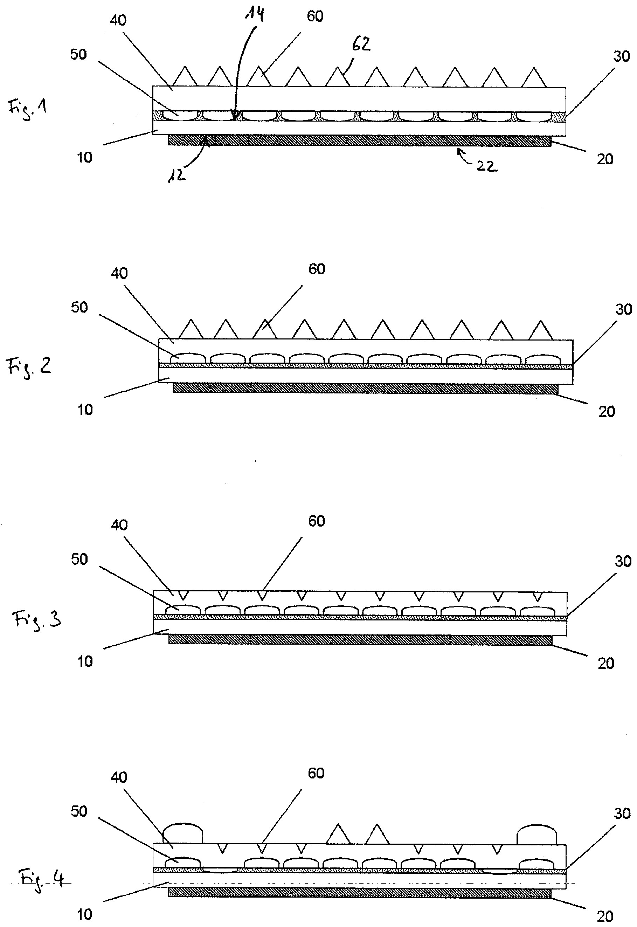

Fig. 1 zeigt eine Querschnitt-Skizze zu einem ersten Beispiel eines nicht erfindungsgemäßen lichtabgebenden Elements. Das Element weist eine (in Fig. 1 nicht gesondert eingezeichnete) flächige OLED oder eine flächige QLED zur Erzeugung eines ersten Lichts auf. Die Anordnung ist dabei mit Bezug auf Fig. 1 derart, dass die flächige OLED bzw. QLED in erster Näherung in einer Ebene angeordnet ist, die normal zu der Zeichenebene orientiert ist. Weiterhin weist das Element ein optisches Beeinflussungselement 40 mit einer Lichtabgabefläche 62 zur Abgabe eines zweiten Lichts auf. Das optische Beeinflussungselement 40 ist vorzugsweise in erster Näherung flächig und dabei parallel zu der OLED bzw. QLED orientiert angeordnet. Das zweite Licht ist dabei durch eine optische Beeinflussung aus dem ersten Licht gebildet, wobei die optische Beeinflussung - zumindest teilweise - durch das optische Beeinflussungselement 40 bewirkt ist.

Die OLED bzw. QLED kann insbesondere eine Grundelektrode, Elementschichten und eine Deckelektrode umfassen. Weiterhin kann das lichtabgebende Element ein Substrat 10 aufweisen, das vorzugsweise ebenfalls in erster Näherung flächig ausgeführt ist und dabei dementsprechend parallel zu der OLED bzw. QLED angeordnet ist. Das Substrat kann zum Beispiel durch eine Glasplatte gebildet sein. Die OLED bzw. QLED ist dabei auf einer ersten Seite 12 des Substrats 10 angeordnet. Vorzugsweise weist das Element außerdem eine Deckschicht 20 auf, vorzugsweise in Form eines Deckglases, wobei die OLED bzw. QLED zwischen dem Substrat 10 und der Deckschicht 20 angeordnet ist. Die Deckschicht 20 weist vorzugsweise einen planen Oberflächenbereich 22 auf, der eine äußere Begrenzung des Elements darstellt. Durch die Deckschicht 20 kann eine Verkapselung der OLED bzw. QLED gebildet sein bzw. ein besonderer Schutz der OLED bzw. QLED vor Beeinflussung von außen.

Mit Bezug auf Fig. 1 ist die Gestaltung des lichtabgebenden Elements derart, dass von der OLED bzw. QLED das erste Licht nach oben abgegeben wird, dieses Licht zunächst das Substrat 10 durchsetzt, im weiteren Verlauf in das optische Beeinflussungselement 40 eintritt und in der weiteren Folge als zweites Licht über die Lichtabgabefläche 62 nach oben aus dem lichtabgebenden Element austritt. Auf seinem Weg zwischen der OLED bzw. QLED und dem Außenraum des lichtabgebenden Elements, der sich an die Lichtabgabefläche 62 anschließt, wird das Licht optisch beeinflusst, und zwar - zumindest teilweise - durch das optische Beeinflussungselement 40. Durch entsprechende Ausgestaltung des optischen Beeinflussungselements 40 lässt sich erzielen, dass ein besonders hoher Anteil des ersten Lichts als zweites Licht das Element verlässt, also eine besonders hohe Lichtausbeute; außerdem lässt sich eine gezielte Beeinflussung des Richtungsverhaltens des zweiten Lichts bewirken, also eine gezielte Lichtlenkung.

Vorzugsweise umfasst das optische Beeinflussungselement 40 hierzu sowohl eine Primäroptik 50, als auch eine Sekundäroptik 60. Dabei kann die Primäroptik 50 zumindest in erster Linie zur Erhöhung der Lichtausbeute ausgebildet sein und die Sekundäroptik 60 zumindest in erster Linie zur Lichtlenkung.

Wie in Fig. 1 skizziert, ist die Sekundäroptik 60 vorzugsweise zumindest teilweise durch eine Strukturierung der Lichtabgabefläche 62 gebildet. Vorzugsweise umfasst die Sekundäroptik 60 Lichtbeeinflussungselemente in Form von Prismen, insbesondere Mikroprismen. Hierdurch ist eine besonders gute, gezielte Lichtlenkung ermöglicht.

Die Sekundäroptik 60 kann auch durch die Prismen gebildet sein, also als Lichtbeeinflussungselemente lediglich die Prismen aufweisen.

Die Primäroptik 50 umfasst vorzugsweise Lichtbeeinflussungselemente in Form von Mikrolinsen; hierdurch ist besonders gut eine Erhöhung der Lichtausbeute ermöglicht. Die Primäroptik 50 kann auch durch die Mikrolinsen gebildet sein, also als Lichtbeeinflussungselemente lediglich die Mikrolinsen aufweisen.

Besonders bevorzugt ist das optische Beeinflussungselement 40 als einteiliges Bauteil ausgebildet. Hierdurch ist eine Relativanordnung der Primäroptik 50 zu der Sekundäroptik 40 bzw. der entsprechenden jeweiligen Lichtbeeinflussungselemente fest vorgegeben, so dass beim Zusammenbau des lichtabgebenden Elements nicht mehr erforderlich ist, auf eine bestimmte gegenseitige Positionierung zwischen Primäroptik und Sekundäroptik zu achten.

Durch die Ausgestaltung des optischen Beeinflussungselements 40 als ein Bauteil lässt sich außerdem erzielen, dass das optische Beeinflussungselement 40 besonders einfach auf das Substrat 10 aufgebracht werden kann.

Wie weiterhin in Fig. 1 exemplarisch skizziert, kann das lichtabgebende Element außerdem eine Verbindungsschicht 30 aufweisen, die in einem Zwischenbereich zwischen einer, der ersten Seite 12 gegenüberliegenden, zweiten Seite 14 des Substrats 10 einerseits und dem optischen Beeinflussungselement 40 andererseits angeordnet ist. Die Verbindungsschicht 30 kann einen Klebstoff umfassen oder aus einem solchen bestehen. Die Verbindungsschicht 30 kann so gestaltet sein, dass sie ebenfalls zur optischen Beeinflussung des ersten Lichts zur Bildung des zweiten Lichts dient bzw. beiträgt. Insbesondere kann die Verbindungsschicht 30 aus einem Material gebildet sein, dessen Brechungsindex auf das Substrat 10 bzw. dessen Material einerseits und das optische Beeinflussungselement 40 bzw. dessen Material andererseits derart abgestimmt ist, dass hierdurch eine Erhöhung der Lichtausbeute bewirkt bzw. gefördert ist.

Vorzugsweise ist das optische Beeinflussungselement 40 durch die Verbindungsschicht 30 an dem Substrat 10 gehaltert, also mechanisch gehalten. Hierdurch ist ein besonders einfacher Aufbau des lichtabgebenden Elements ermöglicht, da auf gesonderte Befestigungselemente zur Halterung des optischen Beeinflussungselements 40 verzichtet werden kann.

Die OLED bzw. QLED kann transparent sein. Hierdurch ist eine Lichtabgabe der OLED bzw. QLED in zwei gegenüberliegende Richtungen ermöglicht, mit Bezug auf Fig. 1 nach oben und nach unten. Wenn außerdem die Deckschicht 20 lichtdurchlässig gestaltet ist, ist eine entsprechende beiderseitige Lichtabgabe des lichtabgebenden Elements ermöglicht.

In den Figuren 2 bis4 sind für jeweils korrespondierende Elemente dieselben Bezugszeichen verwendet.

In Fig. 2 ist eine der Fig. 1 entsprechende Skizze zu einem zweiten, nicht erfindungsgemäßen Beispiel gezeigt. Im Unterschied zu dem ersten Beispiel sind hierbei die Mikrolinsen der Primäroptik 50 invers ausgeführt, also mit Bezug auf die äußere Form des optischen Beeinflussungselements 40 nicht - wie beim ersten Beispiel - als konvex strukturierte Lichtbeeinflussungselemente, sondern als konkav strukturierte Lichtbeeinflussungselemente. Die Primäroptik 50 kann auf diese Weise besonders gut zur Anpassung der Brechzahlen zwischen der Verbindungsschicht 30 und dem Substrat 10 und dem optischen Beeinflussungselement 40 dienen bzw. ausgebildet sein.

Bei dem in Fig. 3 entsprechend skizzierten, dritten, nicht erfindungsgemäßen Beispiel ist auch die Sekundäroptik 60 invers ausgebildet. Wie bei dem in Fig. 4 entsprechend skizzierten, erfindungsgemäßen Beispiel der Fall, kann die Primäroptik 50 sowohl konvex, als auch konkav ausgebildete Lichtbeeinflussungselemente umfassen. Dasselbe gilt für die Sekundäroptik 60.

Wie weiterhin exemplarisch beim erfindungsgemäßen Beispiel gezeigt, kann weiterhin vorgesehen sein, dass das optische Beeinflussungselement 40 - normal zu der Lichtabgabefläche 62 betrachtet - ungleichmäßig ausgebildete Lichtbeeinflussungselemente aufweist. Hierdurch lässt sich sozusagen eine ortsaufgelöste Auskoppel- bzw. Richtwirkung erzielen. Erfindungsgemäß werden - mit Bezug auf die Lichtabgabefläche 62 - in einem Randbereich des optischen Beeinflussungselements 40 anders geformte Mikrolinsen als Lichtbeeinflussungselemente angeordnet sein als in einem mittleren Bereich. Auf diese Weise lässt sich gezielt Einfluss auf die Homogenität der Lichtabgabe über die Lichtabgabefläche 62 hinweg nehmen. Insbesondere lässt sich durch entsprechende Gestaltung die Homogenität der Lichtabgabe erhöhen.

## Patentansprüche

1. Lichtabgebendes Element, aufweisend
- eine flächige OLED oder eine flächige QLED zur Erzeugung eines ersten Lichts,
- ein optisches Beeinflussungselement (40) mit einer Lichtabgabefläche (62) zur Abgabe eines zweiten Lichts,
wobei das zweite Licht durch eine, zumindest teilweise durch das optische Beeinflussungselement (40) bewirkte, optische Beeinflussung aus dem ersten Licht gebildet ist,
wobei das optische Beeinflussungselement (40) eine Primäroptik (50) sowie eine Sekundäroptik (60) zur optischen Beeinflussung umfasst,
wobei die Primäroptik (50) auf einer Seite des optischen Beeinflussungselements (40) ausgebildet ist, die zu der OLED bzw. QLED weist,
**dadurch gekennzeichnet,**
**dass** die Primäroptik (50) Mikrolinsen umfasst, wobei - mit Bezug auf die Lichtabgabefläche (62) - in einem Randbereich des optischen Beeinflussungselements (40) anders geformte Mikrolinsen (50) als Lichtbeeinflussungselemente angeordnet sind, als in einem mittleren Bereich.

2. Lichtabgebendes Element nach Anspruch 1,
bei dem die Sekundäroptik (60) zumindest teilweise durch eine Strukturierung der Lichtabgabefläche (62) gebildet ist.

3. Lichtabgebendes Element nach Anspruch 1 oder 2,
bei dem die Sekundäroptik (60) Prismen umfasst.

4. Lichtabgebendes Element nach einem der vorhergehenden Ansprüche,
bei dem das optische Beeinflussungselement (40) normal zur Lichtabgabefläche (62) betrachtet ungleichmäßig ausgebildete Lichtbeeinflussungselemente aufweist.

5. Lichtabgebendes Element nach einem der vorhergehenden Ansprüche,
bei dem die OLED bzw. QLED eine Grundelektrode, Elementschichten und eine Deckelektrode umfasst.

6. Lichtabgebendes Element nach einem der vorhergehenden Ansprüche,
bei dem das optische Beeinflussungselement (40) ein einteiliges Bauteil ist.

7. Lichtabgebendes Element nach einem der vorhergehenden Ansprüche, weiterhin aufweisend
- ein Substrat (10), wobei die OLED bzw. QLED auf einer ersten Seite (12) des Substrats (10) angeordnet ist, sowie
- eine Verbindungsschicht (30), die in einem Zwischenbereich zwischen einer, der ersten Seite (12) gegenüberliegenden, zweiten Seite (14) des Substrats (10) einerseits und dem optischen Beeinflussungselement (40) andererseits angeordnet ist.

8. Lichtabgebendes Element nach Anspruch 7,
bei dem das optische Beeinflussungselement (40) durch die Verbindungsschicht (30) an dem Substrat (10) gehaltert ist.

9. Lichtabgebendes Element nach Anspruch 7 oder 8,
bei dem die Verbindungsschicht (30) einen Klebstoff umfasst oder aus einem solchen besteht.

10. Lichtabgebendes Element nach einem der Ansprüche 7 bis 9,
weiterhin aufweisend
- eine Deckschicht (20), insbesondere in Form eines Deckglases, wobei die OLED bzw. QLED zwischen dem Substrat (10) und der Deckschicht (20) angeordnet ist.

11. Lichtabgebendes Element nach Anspruch 10,
bei dem die Deckschicht (20) lichtdurchlässig ist.

12. Lichtabgebendes Element nach einem der vorhergehenden Ansprüche,
bei dem die OLED bzw. QLED transparent ist.

## Claims

1. Light-emitting element, comprising
- a planar OLED or a planar QLED for producing a first light,
- an optical influencing element (40) having a light emitting surface (62) for emitting a second light,
wherein the second light is formed from the first light by means of an optical influence caused at least in part by the optical influencing element (40),
wherein the optical influencing element (40) comprises a primary optical system (50) and secondary optical system (60) for optical influencing,
wherein the primary optical system (50) is configured on a side of the optical influencing element (40) that faces toward the OLED or QLED,
**characterized in that**
that the primary optical system (50) comprises microlenses, wherein, with respect to the light emitting surface (62), differently formed microlenses (50) are arranged as light influencing elements in a peripheral region of the optical influencing element (40) than in a central region.

2. Light-emitting element according to claim 1,
in which the secondary optical system (60) is formed at least in part by a structuring of the light emitting surface (62).

3. Light-emitting element according to claim 1 or 2,
in which the secondary optical system (60) comprises prisms.

4. Light-emitting element according to any of the preceding claims,
in which, when viewed normal to the light emitting surface (62), the optical influencing element (40) has unevenly configured light influencing elements.

5. Light-emitting element according to any of the preceding claims,
in which the OLED or QLED comprises a ground electrode, element layers and a cover electrode.

6. Light-emitting element according to any of the preceding claims,
in which the optical influencing element (40) is a one-piece component.

7. Light-emitting element according to any of the preceding claims, further comprising
- a substrate (10), wherein the OLED or QLED is arranged on a first side (12) of the substrate (10), and
- a connecting layer (30), which is arranged in an intermediate region between a second side (12) of the substrate (10) opposite to the first side (14) on the one hand and the optical influencing element (40) on the other hand.

8. Light-emitting element according to claim 7,
in which the optical influencing element (40) is supported on the substrate (10) by the connecting layer (30).

9. Light-emitting element according to claim 7 or 8,
in which the connecting layer (30) comprises or consists of an adhesive.

10. Light-emitting element according to any of the claims 7 to 9, further comprising
- a cover layer (20), in particular in the form of a cover glass, wherein the OLED or QLED is arranged between the substrate (10) and the cover layer (20).

11. Light-emitting element according to claim 10,
in which the cover layer (20) is light-permeable.

12. Light-emitting element according to any of the preceding claims,
in which the OLED or QLED is transparent.

## Revendications

1. Élément luminescent, présentant
- une OLED plate ou une QLED plate destinée à produire une première lumière, et
- un élément modificateur optique (40) possédant une surface d'émission lumineuse (62) destinée à émettre une deuxième lumière,
ladite deuxième lumière étant formée par une modification optique de la première lumière au moins partiellement due à l'élément modificateur optique (40),
ledit élément modificateur optique (40) comprenant une optique primaire (50) ainsi qu'une optique secondaire (60) destinées à ladite modification optique,
ladite optique primaire (50) étant constituée sur un côté de l'élément modificateur optique (40) tourné vers ladite OLED ou QLED ;
**caractérisé en ce que**
l'optique primaire (50) comprend des microlentilles concernant lesquelles, eu égard à la surface d'émission lumineuse (62), des microlentilles (50) servant d'éléments modificateurs de la lumière dans une zone marginale de l'élément modificateur optique (40) présentent une forme différente de celles situées dans une zone médiane.

2. Élément luminescent selon la revendication 1,
dans lequel l'optique secondaire (60) est formée au moins en partie par une structuration de la surface d'émission lumineuse (62).

3. Élément luminescent selon la revendication 1 ou 2,
dans lequel l'optique secondaire (60) comprend des prismes.

4. Élément luminescent selon l'une quelconque des revendications précédentes,
dans lequel l'élément modificateur optique (40) présente des éléments modificateurs de lumière d'aspect irrégulier, vus perpendiculairement à la surface d'émission lumineuse (62).

5. Élément luminescent selon l'une quelconque des revendications précédentes,
dans lequel ladite OLED ou QLED comprend une électrode de base, des couches d'éléments et une électrode de revêtement.

6. Élément luminescent selon l'une quelconque des revendications précédentes,
dans lequel l'élément modificateur optique (40) est un composant unitaire.

7. Élément luminescent selon l'une quelconque des revendications précédentes, présentant en outre
- un substrat (10), ladite OLED ou QLED étant disposée sur un côté (12) du substrat (10), et
- une couche de liaison (30) disposée dans une zone intermédiaire située entre, d'une part, un deuxième côté (14) du substrat (10) qui est opposé au premier côté (12) et, d'autre part, ledit élément modificateur optique (40).

8. Élément luminescent selon la revendication 7,
dans lequel l'élément modificateur optique (40) est monté sur le substrat (10) par le biais de la couche de liaison (30).

9. Élément luminescent selon la revendication 7 ou 8,
dans lequel la couche de liaison (30) comprend un adhésif ou consiste en un adhésif.

10. Élément luminescent selon l'une des revendications 7 à 9, présentant en outre
- une couche de revêtement (20), notamment sous la forme d'un verre de revêtement, ladite OLED ou QLED étant disposée entre le substrat (10) et la couche de revêtement (20).

11. Élément luminescent selon la revendication 10,
dans lequel la couche de revêtement (20) est translucide.

12. Élément luminescent selon l'une quelconque des revendications précédentes,
dans lequel ladite OLED ou QLED est transparente.
